# EUROPEAN PATENT APPLICATION

(11) **EP 4 421 193 A1**
(43) Date of publication of application: **28.08.2024**
(21) Application number: 22839389.8
(22) Date of filing: 19.10.2022
(51) Int. Cl.: C22C 1/02, C22C 9/01, C22F 1/08, C30B 11/00, C30B 29/52, C22C 1/03

(54) **NOVEL MONOCRYSTALLINE SHAPE MEMORY ALLOY FOR CRYOGENIC APPLICATIONS, PRODUCTION METHOD AND USES THEREOF**

(30) Priority: 19.10.2021 ES 202130976
(71) Applicant: Universidad del País Vasco/Euskal Herriko Unibertsitatea, 48940 Leioa, Vizcaya (ES)
(72) Inventor: SAN JUAN NÚÑEZ, José María, 48940 Vizcaya (ES); NÓ SÁNCHEZ, María Luisa, 48940 Vizcaya (ES); LORENZO GARCÍA-MINGUILLÁN, Patricia, 48940 Vizcaya (ES)
(74) Representative: Balder IP Law, S.L.
(86) International application number: PCT/ES2022/070666
(87) International publication number: WO 2023/067224

(57) **Abstract**

The present invention discloses a monocrystalline shape memory alloy consisting of: 11.5 % - 14.0 % Al by weight; 2.5 % - 5.5 % Ni by weight; 0.02 % - 0.58 % Be by weight, the Cu content and impurities being unavoidable. The alloy of the invention may have a martensitic transformation temperature between 400 K and 4.2 K, by adjusting the concentration of the elements thereof. The invention further discloses a method for preparing the alloy comprising the following steps: (i) Obtaining a first homogeneous alloy from a molten mixture of the Cu, Al, Ni and Be elements under an inert atmosphere; (ii) Placing an oriented monocrystalline seed, having a concentration similar to that of the monocrystalline shape memory alloy to be obtained, in a monocrystal growth equipment, by means of the vertical Bridgman or other growth method, and growing an oriented monocrystal by incorporating the first alloy obtained in step (i) into the equipment; (iii) Subjecting the monocrystal obtained in the preceding step, in a precipitated state, to a solubilisation treatment; (iv) Subjecting the monocrystal obtained in the preceding step to a tempering treatment, and (vi) subjecting the monocrystal obtained in the preceding step to an aging treatment until the monocrystalline shape memory alloy is obtained. The invention also discloses various uses of the alloy under temperature conditions from 400 K to 4.2 K.

## Description

### Field of the invention

The present invention relates to a novel monocrystalline Cu-AI-Ni-Be shape memory alloy and very low transformation temperatures. These monocrystalline alloys can be machined and/or milled to prepare parts that find application in the field of low-temperatures, in particular for cryogenic applications.

### Background of the invention

Shape memory alloys **(SMA):** have a thermoelastic martensitic transformation (TM) that confers them the properties of Shape Memory (SM) and Superelastic Effect (SE). The thermoelastic martensitic transformation is reversible and is defined by four temperatures: **Ms** (martensite start, and **Mf** (martensite finish, during cooling, and **As** (austenite start, and **Af** (austenite finish, during heating. The working conditions around these temperatures allow practical exploitation of the indicated SM and SE properties. These properties confer the shape memory alloys, hereinafter also referred to as SMA, the ability to work, for example, as couplings, sensors and actuators in multiple applications across various industrial sectors [T.W. Duerig, K.N. Melton, D. Stöckel, C.M. Wayman (Editors). Engineering aspects of Shape Memory Alloys. Butterworth-Heinemann, London, 1990; K. Otsuka, C.M. Wayman (Editors). Shape Memory Materials. Cambridge University Press, Cambridge, 1998; K. Yamauchi, I. Ohkata, K. Tsuchiya, S. Miyazaki (Editors). Shape memory and superelastic alloys. Woodhead Publishing, Cambridge, 2011; J.M. Jani, M. Leary, A. Subic, M.A. Gibson. A review of shape memory alloys research, applications and opportunities. Materials and Design 56 (2014) 1078-1113.].

Over the past two decades, a great deal of effort has been devoted to the development of high-temperature SMAs, this is, above 100 °C, as this is the maximum utilisation temperature of Ti-Ni, which is the most commercially widespread SMA worldwide. However, so far, very little attention has been paid to the development of SMA with very low transformation temperatures to exploit their potential applications at very low temperatures. This is due to the scientific-technological difficulty in obtaining the transformation temperatures and SM and SE properties at very low temperatures, and it is precisely in these ranges that the present invention falls within.

Low-temperature SMAs such as Ti-Ni based alloys, Cu-Zn based alloys, Cu-Al based alloys and within the latter, the Cu-Al-Ni alloy family and the Cu-Al-Be family particularly standing out, are known in the state of the art.

The Cu-Al-Ni family has been extensively studied and the equation of transformation temperatures with Al and Ni concentration has been accurately established [V. Recarte, R.B. Pérez-Sáez, E.H. Bocanegra, M.L. Nó, J. San Juan. Dependence of the martensitic transformation characteristics on concentration in Cu-Al-Ni shape memory alloys. Materials Science & Engineering A273-275 (1999) 380-384; V. Recarte, R.B. Pérez-Sáez, E.H. Bocanegra, M.L. Nó, J. San Juan. Influence of Al and Ni concentration on the martensitic transformation in Cu-Al-Ni shape memory alloys. Metallurgial and Materials Transactions A 33 (2002) 2581-2591] serving as a reference for future work and patents. As far as the inventors of the present invention are aware, the lowest Ms observed in this family is above 120 K. This is due to the fact that for the concentrations required to obtain low Ms, the alloy has a tendency to precipitate the stable phase γ₁ [J.I. Pérez-Landazabal, V. Recarte, V. Sánchez-Alarcos, M.L. Nó, J. San Juan. Study of the stability and decomposition process of the beta phase in Cu-Al-Ni shape memory alloys. Materials Science & Engineering A 438-440 (2006) 734-737], the properties of the same SMA being lost. In fact, this Cu-Al-Ni family is the most stable of the Cu-Al-based families, because it has an L2₁-type atomic order [J.I. Pérez-Landazabal, V. Recarte, R.B. Pérez-Sáez, M.L. Nó, J. Campo, J. San Juan. Determination of the next-nearest neighbor order in beta phase in Cu-AI-Ni shape memory alloys. Applied Physics Letters 81 (2002) 1794-1796] and because it hardly presents martensite stabilisation problems, for which reason it is the most suitable for working at high temperatures, up to 200 °C.

Cu-Al-Ni alloys have the drawback of being very brittle in the polycrystalline state, because, due to the high elastic anisotropy thereof, a high concentration of stresses is generated at the triple points of the grain boundaries, resulting in microcracks and intergranular fracture [K. Otsuka, C.M. Wayman (Editors). Shape Memory Materials. Cambridge University Press, Cambridge, 1998]. This problem is technically serious because these alloys require a high-temperature thermal treatment to be carried out during which recrystallisation and grain size growth occur.

In view of the above and despite the existence of various SMA alloys there is still a need to provide the state of the art with novel and improved shape memory alloys, that are sufficiently stable metallurgically to be used in practical applications, particularly in cryogenic applications, with transformation and effect temperatures with shape memory and superelasticity below 126.85 °C (400 K) and up to -268.95 °C (4.2 K).

### Description of the Figures

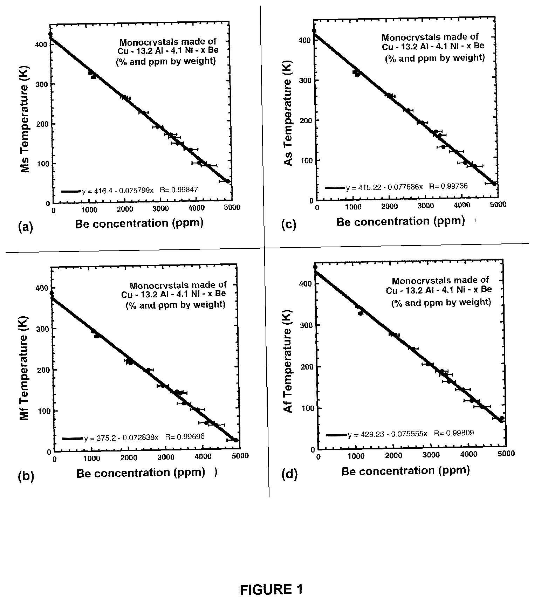

**Figure 1****:** Diagrams showing the line representing the martensitic (a) Ms, (b) Mf, and austenitic (c) As and (d) Af transformation temperatures, as a function of varying Beryllium (Be) concentration (in ppm by weight), percentage by weight), for a series of alloys of the invention, with constant aluminium concentration, Al = 13.2 % by weight, constant nickel concentration, Ni = 4.1 % by weight, and the balance of copper and unavoidable impurities. In all cases the correlation factor of the linear adjustment is 0.997 or better.

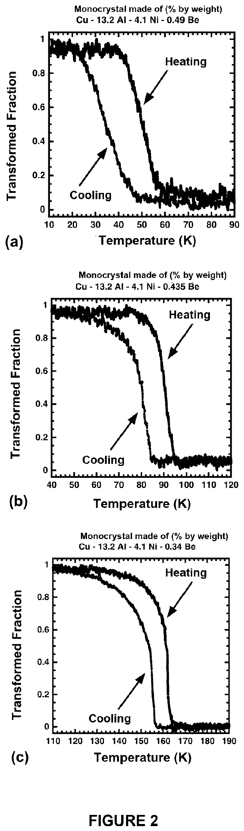

**Figure 2****:** Diagrams showing the martensitic transformation during cooling and heating for three alloys of different concentrations according to the invention.
   (a) Cu-13.2Al-4.1Ni-0.49Be alloy (% by weight), which has Ms = 48 K, Mf = 21.3 K, As = 34.5 K and Af = 67.5 K transformation temperatures.
   (b) Cu-13.2Al-4.1Ni-0.435Be alloy (% by weight), which has Ms = 87.7 K, Mf = 58.6 K, As = 78.5 K and Af = 96.3 K transformation temperatures.
   (c) Cu-13.2Al-4.1Ni-0.34Be alloy (% by weight), which has Ms = 159.1 K, Mf = 137.8 K, As = 147.1 K and Af = 164.7 K transformation temperatures.
**Figure 3****:** Thermal transformation cycle under the different applied stresses of 61.0 MPa, 43.6 MPa and 26.3 MPa, according to the monocrystalline orientation [001] in longitudinal traction, indicated in the graph, in a Cu-13.2AI-4.1Ni-0.205Be alloy (% by weight).
**Figure 4****:** Stress-strain cycles obtained in traction in a mechanical testing machine with temperature chamber, for a Cu-13.2Al-4.1Ni-0.255Be alloy (% by weight), at different temperatures and up to 8% deformation.

### Description of the invention

In a first aspect the invention relates to a novel monocrystalline shape memory alloy consisting of:
(a) 11.5 % - 14.0 % Al by weight;
(b) 2.5 % - 5.5 % Ni by weight;
(c) 0.02 % - 0.58 % Be by weight,
the Cu content and impurities being unavoidable, and
wherein the percentages are expressed by weight with respect to the total weight of the novel monocrystalline shape memory alloy.

The novel monocrystalline shape memory alloy, hereinafter the alloy of the invention, is also characterised in that it has a martensitic (Ms) transformation temperature between 400 K and 40 K, preferably between 400 K and 20 K, more preferably between 400 K and 10 K. and even more preferably between 400 and 4.2 K. This martensitic (Ms) transformation temperature can be adjusted linearly between 400 K and 4.2 K, as a function of the amount of Be present in the alloy.

The novel alloy also exhibits shape memory (SM) and superelastic (SE) effects in the temperature range between 400 K and 40 K, preferably between 400 K and 20 K, more preferably between 400 K and 10 K. and even more preferably between 400 and 4.2 K.

The term "monocrystalline", by its definition indicates that it has no grain boundaries, and referred to the alloy of the invention it relates to the composition of the alloy being a homogeneous composition of the alloying elements, without the presence of preferential segregation of the same in the grain boundaries. The homogeneity of the composition has been determined by means of Inductive Coupled Plasma Vaporisation and detection by means of Optical Emission Spectroscopy (ICP-OES) as detailed in the Examples section.

The monocrystalline alloy of the invention can have any crystallographic orientation, which will depend in each case on the alloy to be obtained. Illustrative examples, non-limiting of the same are [001], [011], or [111]. In preferred embodiments the orientation is [001].

In preferred embodiments the alloy consists of:
(a) 12.0 % - 13.5 % Al by weight;
(b) 3.0 % - 5.0 % Ni by weight;
(c) 0.02 % - 0.58 % Be by weight, or 0.05 % - 0.55 % Be by weight,
the Cu content and impurities being unavoidable,

In other preferred embodiments the alloy consists of:
(a) 12.0 % - 13.5 % Al by weight;
(b) 3.0 % - 5.0 % Ni by weight;
(c) 0.10 % - 0.50 % Be by weight,
the Cu balance and impurities being unavoidable.

In other preferred embodiments the alloy consists of:
(a) 13.2 % Al by weight;
(b) 4.1 % Ni by weight;
(c) 0.10 % - 0.58 % Be by weight, or 0.10 % - 0.55 % Be by weight,
the Cu balance and impurities being unavoidable.

In other preferred embodiments the alloy consists of:
(a) 13.2 % Al by weight;
(b) 4.1 % Ni by weight;
(c) 0.10 % - 0.50 % Be by weight,
the Cu balance and impurities being unavoidable.

In other preferred embodiments the alloy is selected from the following group of alloys:
Cu-13.2Al-4.1Ni-0.49Be (% by weight),
Cu-13.2Al-4.1Ni-0.445Be (% by weight),
Cu-13.2Al-4.1Ni-0.435Be (% by weight),
Cu-13.2Al-4.1Ni-0.41Be (% by weight),
Cu-13.2Al-4.1Ni-0.39Be (% by weight),
Cu-13.2Al-4.1Ni-0.35Be (% by weight),
Cu-13.2Al-4.1Ni-0.34Be (% by weight),
Cu-13.2Al-4.1Ni-0.33Be (% by weight),
Cu-13.2Al-4.1Ni-0.30Be (% by weight),
Cu-13.2Al-4.1Ni-0.26Be (% by weight),
Cu-13.2Al-4.1Ni-0.255Be (% by weight),
Cu-13.2Al-4.1Ni-0.21Be (% by weight),
Cu-13.2Al-4.1Ni-0.205Be (% by weight),
Cu-13.2Al-4.1Ni-0.12Be (% by weight),
Cu-13.2Al-4.1Ni-0.11Be (% by weight),

Characterisation of the alloy of the invention shows that it is metallurgically stable up to more than 500 K and not prone to martensite stabilisation processes.

Temperatures of martensitic transformation of the alloy can be chosen from all the above described temperature ranges: between 400 K and 40 K, preferably between 400 K and 20 K, more preferably between 400 K and 10 K. and even more preferably between 400 K and 4.2 K, by adjusting the composition of the alloying elements, as illustrated in Figures 1 (a), (b), (c) and (d).

The martensitic transformation of these alloys has a low thermal hysteresis, typical of monoclinic martensite. In Figures 2 (a), (b) and (c) the low-temperature transformation cycles are presented, for three alloys where the transformation temperatures and the thermal hysteresis of the transformation are shown.

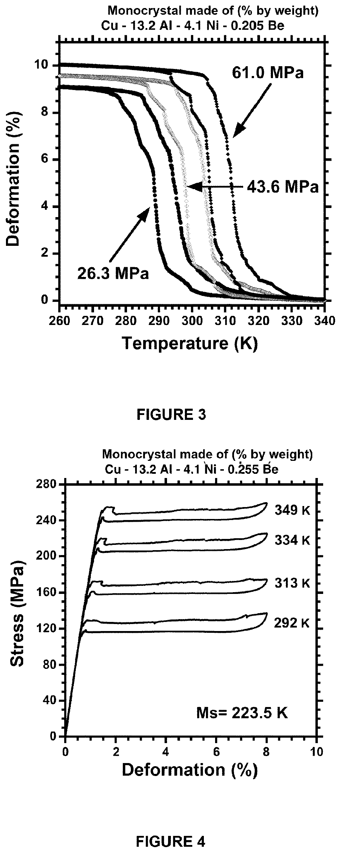

The alloy shows a good shape memory effect in all the above described temperature ranges between: 400 K and 40 K, preferably between 400 K and 20 K, more preferably between 400 K and 10 K. and even more preferably 400 K to 4.2 K, with a small thermal hysteresis between 5 K and 25 K, and preferably between 5 K and 15 K. This can be seen both in Figures 2 (a), (b) and (c), where the thermal transformation is shown, as in Figure 3, where the thermal transformation under load, for a particular alloy, is shown. This, together with the low thermal hysteresis indicated in the previous point, causes the alloy to have very good properties for use thereof in the manufacture of e.g. sensors, actuators or couplings based on shape memory.

The alloy shows a good SE superelastic effect in all the temperature ranges described above: between 400 K and 40 K, preferably between 400 K and 20 K, more preferably between 400 K and 10 K. and even more preferably 400 K to 4.2 K, with low mechanical hysteresis during the superelastic effect, between 10 MPa and 40 MPa and preferably between 10 MPa and 15 MPa. This can be seen in Figure 4 where the superelastic behaviour in traction for an alloy at different temperatures is shown. This indicates that the alloy has very good properties for use in applications and devices based on the superelastic effect.

In another aspect a method for preparing the alloy of the invention is disclosed, hereinafter referred to as the method of the invention, comprising the following steps:
(i) Obtaining a first homogeneous alloy from a molten mixture of the Cu, Al, Ni and Be elements under an inert atmosphere;
(ii) Placing an oriented monocrystalline seed, having a concentration similar to that of the monocrystalline shape memory alloy to be obtained, in a monocrystal growth equipment,
(iii) growing an oriented monocrystal, by incorporating the first alloy obtained in step (i) into the monocrystal growth equipment;
(iv) Subjecting the monocrystal obtained in the previous step, in a precipitated state, to a solubilisation treatment;
(v) Subjecting the monocrystal obtained in the preceding step to a tempering treatment, and
(vi) Subjecting the monocrystalline obtained in the preceding step to an aging treatment until the monocrystalline shape memory alloy is obtained.

In step (i) of obtaining the first homogeneous alloy, high purity elements are used as a starting point. Preferably Cu-Ni and/or Cu-Be master alloys are used. The elements are melted by means of any usual technique, e.g. by induction. Melting is performed under an inert atmosphere, for example of argon. Any suitable container can be used, such as a crucible, in particular a graphite crucible. The molten mixture is then cast. In a particular embodiment the casting is performed by centrifugation in a graphite die. The result of step (i) is the obtention of a first alloy of homogeneous concentration. The concentration of the elements in the alloy and the homogeneity thereof were controlled by means of the method of analysis Inductive Plasma Vaporisation and detection by means of Optical Emission Spectroscopy to ensure that the concentrations were within the ranges defined in the present invention for the novel alloy.

The method of the invention further comprises a step of preparing a crystalline seed for use in step (ii). In preferred embodiments, said monocrystalline seed is prepared with the same or similar concentration to that of the monocrystalline shape memory alloy to be obtained in each case. In particular embodiments said seed is obtained from a previously oriented monocrystal, or from a monocrystal grown seedless and subsequently cut and milled by means of conventional methods. Preferably the seed has a composition equal or similar to that of the alloy prepared to grow the monocrystal to be obtained. The monocrystalline seed is oriented longitudinally according to the desired crystalline direction, for example [001].

By "similar" should be understood a composition within the range indicated in the first paragraph of the description of the invention, and preferably of the same composition in all or some of the elements, than the monocrystal to be grown.

Then in step (iii) the growth of the oriented monocrystal is carried out. Growth can be carried out, for example by means of the vertical Bridgman method, or by means of another conventional method that allows an oriented monocrystal to be grown. The method is carried out in a suitable monocrystal growth equipment, such as a crucible, wherein the monocrystalline seed is placed, then incorporating the first alloy into the equipment. The resulting monocrystal obtained is in a precipitated state and it is necessary to subject it to the treatments of steps (iv) to (vi) to achieve the monocrystalline shape memory alloy of the present invention.

The resulting monocrystal obtained in step (iii) is subjected to a solubilisation thermal treatment. In preferred embodiments this thermal treatment is carried out at a temperature comprised between 700 °C and 1000 °C, preferably between 750 °C and 975 °C more preferably between 850 °C and 950 °C, and even more preferably at 900 °C. The time required for this step depends in each case on factors such as the composition of the alloy, the size of the part, the temperature, but can be easily determined by a person skilled in the art. In particular embodiments the time is typically comprised between 25 and 60 minutes. The treatment is carried out under an inert atmosphere, preferably under an argon atmosphere.

The monocrystal resulting from step (iv) is then subjected to a quenching thermal treatment to obtain the metastable austenite phase. The tempering treatment comprises bringing the monocrystal from the temperature of the preceding step to a temperature between 100 °C and 0 °C, or preferably at a temperature between 50 °C and 0 °C, most preferably at 0 °C. In a preferred embodiment it is carried out, for example, immersing it in a water bath at 0 °C.

Subsequently, the monocrystal is subjected to an aging treatment, which makes it possible to stabilise the atomic order of the austenite, the monocrystalline shape memory alloys of the invention being obtained. The time required until the monocrystalline alloy of the invention is obtained may vary depending on factors such as the composition of the alloy, the size of the part, or the temperature at which aging is carried out, etc. Nevertheless, time is typically 24 hours. In preferred embodiments it is carried out at temperatures between 150 and 200 °C; for example at 180 °C.

Another aspect discloses the use of the alloy of the invention, or of the alloy obtained according to the method of the invention at a temperature between 400 K and 40 K, preferably between 400 K and 20 K, more preferably between 400 K and 10 K. and even more preferably 400 K to 4.2 K. In particular embodiments said use may furthermore be under conditions of stress, compression, bending, torsion, or mixtures of the above.

In particular embodiments the use of the alloy falls within cryogenic and/or aerospace applications.

In particular embodiments the use of the alloy of the invention may be as a part of the following elements, or the entirety thereof:
- Temperature thermostats, such as sensors and actuators.
- Actuators of various types, such as valves or other devices, for cryogenic liquids such as He, H, N, O, Ar, etc.
- Couplings of different types based on the shape memory effect, such as detachable pipe joints in cryogenic applications, below 400 K, preferably below 120 K.
- Mechanical vibration damping devices.
- Cooling devices that make use of the elasto-caloric effect based on the transformation enthalpy of martensitic transformation.

In particular embodiments the alloy of the invention can be used in any application in which it is necessary to employ a shape memory alloy, preferably in the low temperature range at a temperature between 400 K and 40 K, preferably between 400 K and 20 K, more preferably between 400 K and 10 K. and even more preferably 400 K to 4.2 K. Illustrative examples are, for example, the use in cryogenic and superconducting devices, wherein currently, as far as the inventors are aware, no other conventional shape memory alloy can be applied.

These applications of the novel alloy fall within various industrial sectors, such as the chemical industry, the industry of large scientific facilities, the superconductor industry, the bio-medical industry, the aviation industry and the aerospace industry, among others.

Next, illustrative examples of the invention are provided, which in no case should be interpreted as limiting the scope of protection of the invention.

### Examples

### Example 1:

As exemplary embodiment of the invention, fourteen monocrystalline Cu-Al-Ni-Be quaternary alloys were produced, (including the Be-free alloy for reference), wherein the concentrations of Al = 13.2 % ± 0.1 % and Ni = 4.1 % ± 0.1 % have been kept constant, and variable concentrations of Beryllium (Be) between 0.10% and 0.50 % ± 0.005 %, (weight in percentage by weight measured in ppm), and the balance being up to 100 % copper and unavoidable impurities.

### Alloy production: growth of monocrystals and thermal treatments

The alloys were prepared according to the method of the invention. Specifically, high purity elements, Cu, Al, and Cu-Ni and Cu-Be master alloys were used as a starting point, according to the desired composition for each of the alloys to be obtained, which melted under an inert argon atmosphere, in a graphite crucible, and a centrifugal casting was carried out in a graphite die. For better control of quaternary alloy compositions, both Ni and Be have been added by means of Cu-Ni and Cu-Be master alloys previously prepared using the same method.

The composition of the cast alloys and monocrystals was measured as indicated below in the present specification.

A longitudinally oriented monocrystalline seed was prepared according to the crystalline direction [001], from a previously oriented monocrystal, or from a monocrystal grown seedless and subsequently cut and milled by means of conventional methods. The seed had a composition similar to that of the alloy prepared to grow the monocrystal.

Monocrystal growth was then carried out using the vertical Bridgman method, with the seed obtained, in a graphite crucible.

After the growth process, monocrystals of quaternary alloys did not have the properties of SMA, since at the end of the process they are in their precipitated state. Therefore, the functionalisation thermal treatments were carried out: A solubilisation treatment at 900 °C for 30 minutes under an argon atmosphere. A quenching treatment from 900 °C to 0 °C to obtain the metastable austenite phase, followed by a 24-hour aging treatment at 180 °C to stabilise the atomic order of the austenite to obtain monocrystalline shape memory alloys.

Subsequently, the obtained monocrystalline alloys were characterised showing the martensitic transformation and the functional properties of shape memory and superelasticity.

### Characterisation of temperatures and properties.

Figure 1 shows the transformation temperatures for this series of alloys of the invention, wherein Be's concentrations have been changing, obtaining the transformation temperatures from 400 K to 48 K for Ms, or between 400 K and 21 K for Mf. The different figures (a, b, c and d) have respectively depicted the evolution of the Ms (martensite start), Mf (martensite finish), As (austenite start) and Af (austenite finish) transformation temperatures.

Transformation temperatures were measured by differential scanning calorimetry (DSC), and by measuring the electrical resistance, as indicated below.

In all cases, e.g. of Ms versus Be percentage by weight, the line obtained has a linear adjustment with a correlation factor of 0.997, and shows how the martensitic Ms transformation temperature can be controlled between 400 K and 48 K, or between 400 K and 21 K for Mf, (as well as the other characteristic temperatures), in a linear manner, by controlling Beryllium concentration.

The line on the graph has been extrapolated to 0 K, in order to obtain the maximum Be concentration required, which in this particular case is 0.55 % by weight.

Figure 2 shows the complete martensitic transformation cycle for three specific alloys. These three illustrative examples show the manner in which the alloy of the invention can be designed and controlled to have the transformation temperatures at different temperatures, even below the temperature of liquid nitrogen (78 K), with a transformation thermal hysteresis of only 10 K. It should be noted that, in the first case, alloy (a) has all transformation temperatures below the temperature of liquid nitrogen (78 K).

Figure 3 shows the thermal transformation cycle under different applied stresses according to the monocrystalline orientation [001] in longitudinal traction, indicated in the graph, in a Cu-13.2Al-4.1Ni-0.205Be alloy (% by weight). This graph indicates the good behaviour of the shape memory effect in these novel alloys.

Figure 4 shows the stress-strain cycles obtained in traction in a mechanical testing machine with temperature chamber as shown below, for a Cu-13.2AI-4.1Ni-0.255Be alloy (% by weight), at different temperatures and up to 8% deformation. As can be seen in the graph, the deformation induced by the transformation is fully recoverable and indicates the good superelastic behaviour of this novel family of alloys.

### Equipment and methods used in the characterisation of the alloys of the invention

### Measurement of the composition and homogeneity of the alloy and of the monocrystal:

ICP-OES (Inductive Coupled Plasma with Optical Emission Spectroscopy). Inductive plasma vaporisation and detection by means of optical emission spectroscopy. Chemical analysis method with ppm resolution by weight. It employs standard dissolution and calibration processes. The equipment used was a Perkin Elmer ICP-OES, model 8300. This equipment has been used for the chemical analysis of the elements contained in the alloy, and in particular to determine the Be composition by weight with parts per million (ppm) resolution.

This method of analysis has also been used to determine the compositional homogeneity of the alloy, measuring the composition at the two ends of an ingot obtained and verifying that the deviation was within the error limits indicated in the exemplary embodiment of the invention.

### Measurement of martensitic transformation temperatures and of its hysteresis:

Measurement by means of differential scanning calorimetry, DSC. Standard method for the measurement of phase transformations. The equipment used was a Thermal Analysis DSC, model Q2000. The thermal flux (W/g) as a function of temperature (K) during heating and cooling was measured, with a 10 K/min ramp and Helium gas flow inside the measuring cell. The baseline has been subtracted from the measured thermal flow thermograms using a polynomial of degree 4 and then they have been integrated to obtain the normalised transformed fraction.

Martensitic transformation temperatures (K) were determined at 5 % and at 95 % of the transformed fraction curve. The thermal hysteresis (K) of the transformation was obtained as the width of the thermal transformation cycle at 50 % of the transformed fraction.

This method has been used to measure transformation temperatures and hysteresis between 400 K and 130 K, (since standard DSC equipment does not allow further cooling).

Measurement by variation of the electrical resistance. For very low temperature transformation measurements, up to 10 K in the exemplary embodiment of the invention, the four-prong system of measuring electrical resistance has been used. For this purpose, a closed-circuit helium gas cooling equipment was used, of the Janis Research Company INC brand, model CCS-150. The cooler operates with a Lake Shore Cryotronics temperature controller, model 335, with a diode temperature sensor DT-70B-CU. Measurements between 10 and 300 K were carried out with a heating and cooling rate of 0.5 K/min. The electrical resistance was measured with an Agilent current source, model B2912A, with a stable current of 50 mA and resolution of 0.01 pA, which at the same time allows to measure the voltage difference with a resolution of 0.01 micro volt. The baseline has been subtracted from the resistance measurement by a polynomial of degree 5, to obtain the normalised transformed fraction.

Martensitic transformation temperatures (K) were determined at 5 % and at 95 % of the transformed fraction curve. The thermal hysteresis (K) of the transformation was obtained as the width of the thermal transformation cycle at 50 % of the transformed fraction. As in **Figure 2****.**

This method has been used to measure the transformation temperatures and thermal hysteresis between 300 K and 10 K, in the exemplary embodiment of the invention.

The two methods of DSC and electrical resistance are equivalent with respect to the measurement of martensitic transformation temperatures, giving the same results in the temperature range in which the two measurements overlap, within the ± 5 K error range shown in **Figure 1****.**

### Measurement of Shape Memory Effect

For the measurement of the shape memory effect during martensitic transformation under load, as in **Figure 3****,** laboratory equipment has been used which measures, during a thermal heating-cooling cycle, the deformation as a function of temperature under a load applied in stress on the monocrystal sample. The thermal cycle was carried out by means of a Lauda thermostatic oil bath, model ProLine RP890, programmable between -90 °C and +200 °C and the temperature was measured with a K-type thermocouple in contact with the sample. Longitudinal deformation was measured with a Schaevitz Sensors inductive sensor, model LVDT MHR500. The applied load was measured with an Entran miniature load cell, model MSC6.

### Measurement of the superelastic effect

For the measurement of the superelastic effect in which the martensitic transformation is induced by the application of a mechanical stress, as in **Figure 4****,** an Instron 4467 traction machine with an Instron 3119-006 temperature chamber and equipped with a 10 kN load cell and an Instron 2630-102 extensometer with a resolution micrometer was used. The set allows working at different temperatures between 20 °C and 200 °C which is measured with a K-type thermocouple placed in contact with the sample. Assays, as shown in Figure 4, were carried out at constant temperature and a deformation rate of 10⁻³ s⁻¹.

### Measurement of crystalline orientation of the monocrystal using an Electron Back-Scatter Diffraction detector (EBSD)

To measure the crystalline orientations of the monocrystal, sheets of the monocrystal were cut perpendicular to the growth axis thereof, and after metallographic polishing, they were introduced into a JEOL scanning electron microscope, model JSM 7000F equipped with a Gatan heating platen, model C1003. After heating the monocrystalline sheet above the corresponding Af thereof, so that it is in the austenite phase, the crystalline orientation thereof has been verified.

For this purpose, an electron back-scatter electron diffraction detector EBSD has been used to obtain the Kikuchi line diffraction patterns that allow the crystalline orientation of the sheet under observation to be determined. The detector used was of the HKL brand, Nordlys II model, which operates with the "Flamenco" programme of Oxford Instruments for indexing. It has been verified that all the monocrystals corresponding to the exemplary embodiment of the invention, have a crystalline orientation [001] of the cubic austenite structure, determined with high values of the adjustment parameters.

The invention is not limited to the specific embodiments described above but also encompasses, for example, the variants which can be performed by the person of average skill in the art within the meaning of the claims.

## Claims

1. A monocrystalline shape memory alloy consisting of:
(a) 11.5 % - 14.0 % Al by weight;
(b) 2.5 % - 5.5 % Ni by weight;
(c) 0.02 % - 0.58 % Be by weight,
the Cu content and impurities being unavoidable.

2. The alloy according to claim 1 having a martensitic transformation temperature comprised between 126.85 °C (400 K) and -268.95 °C (4.2 K).

3. The alloy according to any one of claims 1 or 2 consisting of:
(a) 12.0 % - 13.5 % Al by weight;
(b) 3.0 % - 5.0 % Ni by weight;
(c) 0.02 % - 0.58 % or 0.05 % - 0.55 % Be by weight,
the Cu content and impurities being unavoidable.

4. The alloy according to any one of claims 1 to 3 consisting of:
(a) 12.0 % - 13.5 % Al by weight;
(b) 3.0 % - 5.0 % Ni by weight;
(c) 0.1 % - 0.50 % Be by weight,
the Cu content and impurities being unavoidable.

5. The alloy according to any one of claims 1 to 2 consisting of:
(a) 13.2 % Al by weight;
(b) 4.1 % Ni by weight;
(c) 0.10 % - 0.58 % Be by weight, or 0.10 % - 0.55 % Be by weight,
the Cu content and impurities being unavoidable.

6. The alloy according to any one of claims 1 to 2 consisting of:
(a) 13.2 % Al by weight;
(b) 4.1 % Ni by weight;
(c) 0.10 % - 0.50 % Be by weight,
the Cu content and impurities being unavoidable.

7. The alloy according to any one of the preceding claims selected from:
Cu-13.2Al-4.1Ni-0.49Be (% by weight),
Cu-13.2Al-4.1Ni-0.445Be (% by weight),
Cu-13.2Al-4.1Ni-0.435Be (% by weight),
Cu-13.2Al-4.1Ni-0.41Be (% by weight),
Cu-13.2Al-4.1Ni-0.39Be (% by weight),
Cu-13.2Al-4.1Ni-0.35Be (% by weight),
Cu-13.2Al-4.1Ni-0.34Be (% by weight),
Cu-13.2Al-4.1Ni-0.33Be (% by weight),
Cu-13.2Al-4.1Ni-0.30Be (% by weight),
Cu-13.2Al-4.1Ni-0.26Be (% by weight),
Cu-13.2Al-4.1Ni-0.255Be (% by weight),
Cu-13.2Al-4.1Ni-0.21Be (% by weight),
Cu-13.2Al-4.1Ni-0.205Be (% by weight),
Cu-13.2Al-4.1Ni-0.12Be (% by weight),
Cu-13.2Al-4.1Ni-0.11Be (% by weight).

8. A method for preparing the alloy defined in the preceding claims comprising the following steps:
i) Obtaining a first homogeneous alloy from a molten mixture of the Cu, Al, Ni and Be elements under an inert atmosphere;
ii) Placing an oriented monocrystalline seed with a concentration similar to that of the desired monocrystalline shape memory alloy to be obtained in a monocrystal growth equipment;
iii) growing an oriented monocrystal, by incorporating the first alloy obtained in step (i) into the monocrystal growth equipment;
iv) Subjecting the monocrystal obtained in the preceding step, in a precipitated state, to a solubilisation treatment;
v) Subjecting the monocrystal obtained in the preceding step to a tempering treatment, and
vi) Subjecting the monocrystal obtained in the preceding step to an aging treatment until the monocrystalline shape memory alloy is obtained.

9. The method according to claim 8, wherein step (i) is carried out by induction melting of the elements, under an inert atmosphere, followed by casting of the molten mixture by centrifugation in a graphite die, the first homogeneous alloy being obtained.

10. The method according to claim 8 or 9, additionally comprising a step for obtaining a monocrystalline seed.

11. The method according to any one of claims 8 to 10, wherein the resulting monocrystal obtained in step (iii) is subjected to a solubilisation thermal treatment at a temperature comprised between 700 °C and 1000 °C under an inert atmosphere.

12. The method according to any one of claims 8 to 11, wherein the monocrystal resulting from step (iv) is subjected to a tempering thermal treatment comprising bringing the monocrystal from the temperature of the preceding step (iii) to a temperature comprised between 100 °C and 0 °C.

13. The method according to any one of claims 8 to 12, wherein the monocrystal resulting from step (v) is subjected to an aging treatment, at a temperature between 150 and 200 °C.

14. A use of the alloy according to any one of claims 1 to 7 or obtained according to the method according to any one of claims 8 to 13, under temperature conditions comprised between 400 K to 4.2 K.

15. The use, according to claim 14, wherein said use is under conditions of stress, compression, bending, torsion, or mixtures of the above.

16. The use of the alloy according to claim 14 or 15, wherein the alloy is part or all of an element selected from the following elements:
• Temperature thermostats, such as sensors and actuators,
• Actuators of various types, such as valves or other devices for cryogenic liquids such as He, H, N, O, Ar, etc.,
• Couplings of different types based on the shape memory effect, such as detachable pipe joints in cryogenic applications, below 400 K, preferably below 120 K,
• Mechanical vibration damping devices, and
• Cooling devices that make use of the elasto-caloric effect based on the transformation enthalpy of martensitic transformation.
